Europäisches Patentamt

European Patent Office

Office européen des brevets

(11) Publication number: 0 314 399
A2

# EUROPEAN PATENT APPLICATION

(21) Application number: 88309902.0

(22) Date of filing: 21.10.88

(51) Int. Cl.4: H01L 29/90

(30) Priority: 30.10.87 US 115260

(43) Date of publication of application:
03.05.89 Bulletin 89/18

(84) Designated Contracting States:
DE FR GB IT NL

(71) Applicant: PRECISION MONOLITHICS INC.
1500 Space Park Drive
Santa Clara California 95052(US)

(72) Inventor: Smith, Douglas S.
125 Connemara Way No. 165, Sunnyvale
California 94087(US)
Inventor: Bowers, Derek F.
1502 Harrison Court Sunnyvale
California 94087(US)

(74) Representative: Crawford, Andrew Birkby et al
A.A. THORNTON & CO. Northumberland
House 303-306 High Holborn
London WC1V 7LE(GB)

(54) Buried zener diode and method of forming the same.

(57) A buried zener diode and fabrication method are disclosed in which contacts are made to the underside of the anode (56) by means of lateral contact regions (58) and an underlying contact layer (50), as opposed to the prior technique of making contact to lateral portions of the anode (12) through a lightly doped well (8). The fabrication method reduces the number of fabrication steps required by forming the contact layer (50), anode (56) and lateral contact regions (58) in the same steps as those used to form the surrounding isolation ring in an "up-down" diffusion process.

FIG.5.

## BURIED ZENER DIODE AND METHOD OF FORMING THE SAME

### BACKGROUND OF THE INVENTION

#### Field of the Invention

This invention relates to zener diodes, and more particularly to zener diodes having a buried breakdown junction and to integrated circuit methods for forming the same.

#### Description of the Prior Art

Zener diodes are typically fabricated for integrated circuit applications with their breakdown junction below the surface of the semiconductor wafer in which they are set. The wafer is typically silicon, but other materials can also be used. The restriction of the zener breakdown to a region below the surface has been found to enhance the stability of the device.

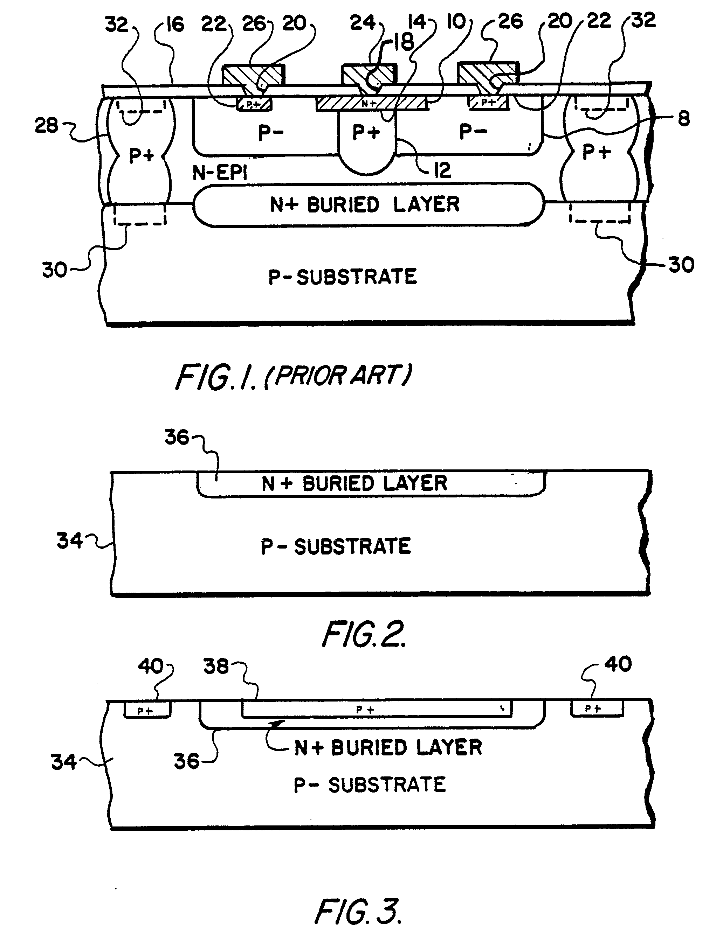

A typical zener diode of known construction is shown in FIG. 1. The device is formed upon a relatively lightly doped p- substrate 2. An n- epitaxial layer 4 is grown over the substrate, with an n+ buried layer 6 formed at the interface of the substrate and epitaxial layer to provide vertical isolation for the zener diode to be described. Although in theory the arrangement of p/n doping polarities could be reversed from that shown in FIG. 1, in practice there are significant fabrication problems in implementing a device with reversed polarities.

A p- well 8 is set in the epitaxial layer over the buried layer 6, and defines the zener diode region. An n+ diode cathode 10 is centrally located at the surface of the well, with a p+ anode region 12 extending down through the well from the underside of cathode 10. A zener junction 14 is formed at the interface of cathode 10 and anode 12.

To provide contacts for the device, an insulating oxide layer 16 is laid down over the epitaxial layer, with a cathode window 18 through the oxide layer over cathode 10, and anode windows 20 through the oxide layer lateral to cathode 10. P+ diffusions 22 are provided in the epitaxial layer immediately below anode windows 20 to establish good contacts with the p- well. Metal contacts 24, 26 are then flowed through the oxide layer windows to provide cathode and anode contacts 24 and 26, respectively. The device is electrically segregated from adjacent devices by means of a lateral isolation ring 28 which extends vertically between oxide layer 16 and substrate 2, and surrounds the diode. Isolation ring 28 is typically formed in an "up-down" process in which concentrations of p+ dopant are initially located immediately below and at the top of the epitaxial layer; the lower and upper initial doping concentrations are indicated in dashed lines by reference numerals 30 and 32, respectively. The wafer is then heated for a period of time, causing the ions to diffuse upward from concentrations 30 and down from concentrations 32. Eventually the diffused ions meet to form a continuous unified isolation ring which extends through the entire vertical depth of the epitaxial layer, and surrounds the zener diode.

In operation, electric conduction takes place between anode contacts 26 and cathode contact 24 through the p- well 8, p+ anode region 12 and n+ cathode 14. It is important that the p- well not be doped too heavily, or else part of the zener breakdown action may occur at the surface interface of cathode 10 and the p- well; this would violate the basic purpose of burying the zener junction. The necessity of making the p- well less than fully conductive, however, introduces an undesirable parasitic resistance between the anode contacts 22 and the p+ anode region 12. The dual anode contact configuration shown mitigates this problem somewhat, but not completely.

Another important disadvantage of the above approach is that it requires extra processing steps to implement. In one processing approach an isolation ring 28 is formed in one series of process steps, the p- well is formed in a separate additional step, and the p+ anode region is formed in a second additional step. In another prior approach, the p+ anode region is formed by the same general type of process and in the same fabrication steps as the upper portion of isolation ring 28. Specifically, a p+ doping concentration is deposited in the epitaxial layer over the planned anode region concur rently with the deposition of upper p+ doping concentrations 32, and the anode region 12 is formed from that doping concentration in the same thermal diffusion step as that used to form the upper portion of isolation ring 28. However, this approach still requires an additional process step to form the p- well, and does not solve the parasitic resistor problem.

### SUMMARY OF THE INVENTION

In view of the above problems with the prior art, the principle objects of the present invention are to provide a buried zener diode structure and a fabrication process which do not require any additional process steps for the formation of either the anode region or the anode contacts, and which greatly reduce the parasitic resistance between the anode and its contacts.

These objects are achieved with the present invention by using the same process steps required to fabricate the isolation ring to also fabricate both the anode region and lateral contacts therefor. This utilizes an "up-down" diffusion process in which an electrically conductive contact layer is diffused up from a doping concentration in the buried layer, while both the anode region and lateral conductive contact regions are diffused down from the upper portion of the structure into contact with the underlying contact layer. The lateral contact regions provide electrical access to the underside of the anode region through the contact layer, and completely eliminate the need for the prior lightly doped well.

The contact layer is formed in a common "up" diffusion with the lower portion of the isolation ring, while the anode region and lateral contact regions are formed in a common "down" diffusion with the upper portion of the isolation ring. Thus, the basic zener structure is created without the need for steps additional to those already required to form the isolation ring. Once the anode region and its lateral contact region are in place, the cathode and metallic device contacts are formed in a conventional manner.

These and other features and advantages of the invention will be apparent to those skilled in the art from the following detailed description of a preferred embodiment, taken together with the accompanying drawings, in which:

DESCRIPTION OF THE DRAWINGS

FIG. 1 is a sectional view of a prior art buried zener diode;

FIG. 2 is a sectional view of the starting substrate for a buried zener diode formed in accordance with the invention, with an oppositely doped buried layer set in the substrate;

FIG. 3 is a sectional view of the zener diode structure of FIG. 2 at a later stage in its fabrication, in which doping concentrations have been formed in the buried layer and in lateral portions of the substrate;

FIG. 4 is a sectional view of the structure of FIG. 3 at a later stage of fabrication, in which an epitaxial layer has been formed over the substrate with various doping concentrations in the upper portion of the epitaxial layer;

FIG. 5 is a sectional view of the structure of FIG. 4 at a later stage in the fabrication process, showing the contact layer, anode region, lateral contact regions and isolation ring formed as a result of thermal diffusion;

FIG. 6 is a sectional view of the structure of FIG. 5 at a later stage in the fabrication process, in which contact doping concentrations have been deposited in the lateral anode contact regions;

FIG. 7 is a sectional view of the structure of FIG. 6 at a later stage in the fabrication process, in which a cathode region has been deposited over the central anode region;

FIG. 8 is a sectional view of the structure of FIG. 7 at a later stage in the fabrication process, in which an oxide layer and metallic contacts have been added to the structure; and

FIG. 9 is a plan view of the zener diode structure of FIG. 8.

DETAILED DESCRIPTION OF A PREFERRED EMBODIMENT

Referring first to FIG. 2, an early stage in the fabrication of a novel buried zener diode constructed in accordance with the invention as shown. A lightly doped p- substrate 34 of silicon or other suitable semiconductor material has an n+ buried layer 36 set in a portion of its upper surface. Although layer 36 is exposed at this point in the fabrication process, it is later buried under an epitaxial layer and is accordingly referred to as a "buried layer". Its doping must be sufficient to vertically isolate the substrate from the overlying zener diode structure. At this point the device structure is similar to that at an early stage in the fabrication of the FIG. 1 prior art device.

The buried layer can be deposited in the substrate by various processes, such as gaseous diffusion or ion beam implantation with the remainder of the substrate masked. As explained below, the n+ dopant should exhibit a relatively slow rate of thermal diffusion; antimony is a suitable dopant for this purpose.

The next step in the fabrication process is illustrated in FIG. 3. P+ dopant concentrations 38 and 40 have been deposited into the upper surfaces of the buried layer and the substrate lateral to the buried layer, respectively. Again, the dopant deposition can be accomplished by techniques such as gaseous diffusion or ion implantation. The p+ dopant should exhibit a relatively rapid thermal diffusion, and for this purpose boron is a suitable dopant material.

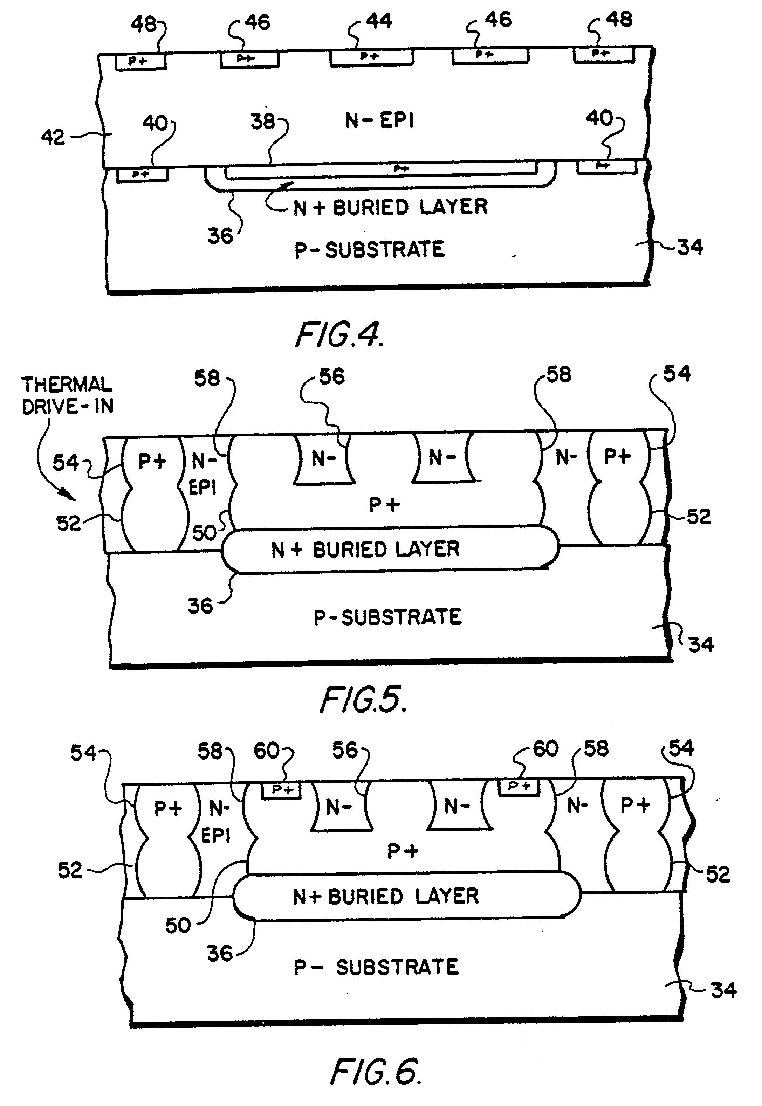

In the next stage of fabrication, shown in FIG. 4, an epitaxial layer 42 has been epitaxially grown over the substrate and its various dopant concentrations described above. The epitaxial layer 42 has a light n- doping, and its thickness will depend upon the ultimate application intended for the device. A thickness of about 4 microns is typical for high speed applications, while a thickness in the order of 20 microns is suitable for high voltage applications. The epitaxial layer is preferably grown at a relatively low temperature, such as 800°C, at which the p+ dopant concentrations 38 and 40 do not diffuse significantly.

Various additional p+ dopant concentrations are then formed in the upper surface of the epitaxial layer. A first concentration 44, which will eventually become the diode anode, is aligned over a central portion of the dopant concentration 38. Laterally spaced from the central concentration 44 are a pair of p+ concentrations 46 which are aligned over lateral portions of the dopant concentration 38. Another pair of p+ concentrations 48 are spaced laterally from concentrations 46 and aligned over lower concentrations 40; concentrations 48 will eventually form the upper portion of an isolation ring. Although concentrations 40 and 48 are shown as separate areas in the two-dimensional rendering of FIG. 4, in actuality they extend completely around the diode device to isolate it from other devices on the wafer.

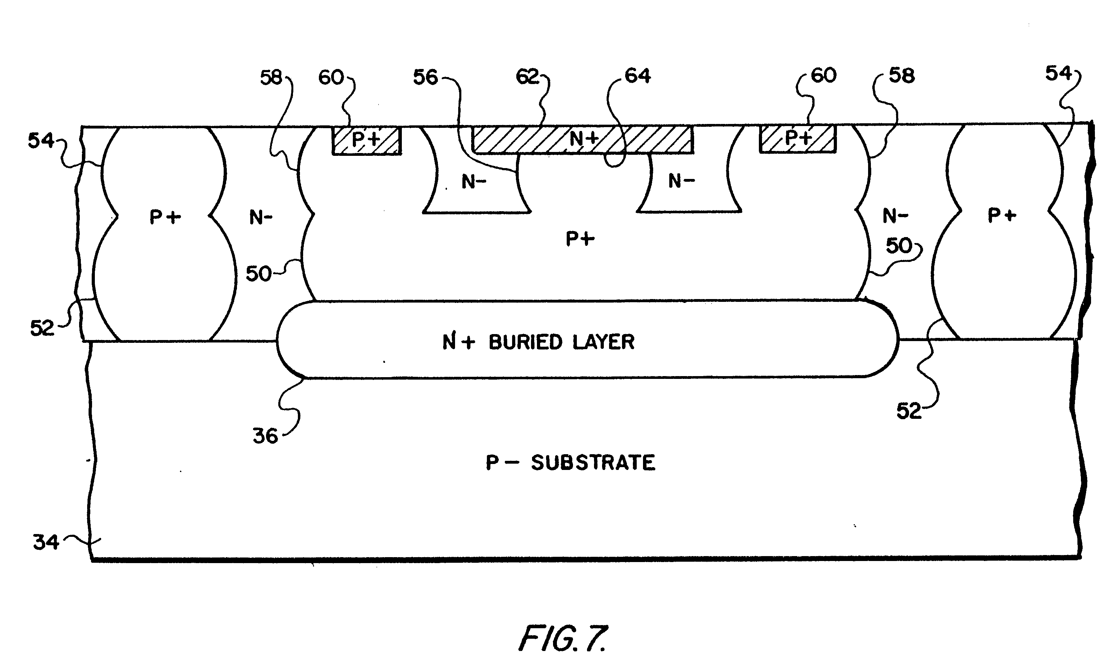

The next step in the fabrication process is a thermal drive-in or diffusion step, the results of which are shown in FIG. 5. The device is placed in a furnace and heated to a temperature of about 1,000°C - 1,300°C for a period of up to several hours at the lower temperatures. A relatively low drive-in temperature of about 1,100°C is generally preferred to avoid lattice damage, but requires a relatively long drive-in period.

As a result of the heating, dopant ions diffuse away from the various doping concentrations described above. The thermal drive-in is continued until the p+ concentration 38 expands upward from the buried layer 36 to form a contact layer 50 which extends along the upper side of the buried layer; the term "contact layer" is used to indicate that this p+ layer is electrically conductive and provides part of the anode contact path for the ultimate diode. P+ dopant concentrations 40 similarly diffuse upward to form the lower portion 52 of an isolation ring, while the upper p+ concentrations 48 diffuse downward to contact lower isolation ring portion 52 and form the upper portions 54 of a completed isolation ring that extends vertically through the entire depth of the epitaxial layer.

The same thermal drive-in causes upper p+ dopant concentration 44 to diffuse downward into an anode region 56, and upper p+ dopant concentrations 46 to diffuse downward into lateral p+ contact regions 5B. Both anode region 56 and lateral contact region 58 extend into and establish electrical contact with the upper side of contact layer 50. The lateral contact regions 58 are spaced and isolated from the lateral sides of anode region 56 by the n- epitaxial layer, the resistivity of which is typically about 1-5 ohm-cm, but make electrical contact with the underside of the anode region through contact layer 50.

It can be seen that buried layer 36 has also diffused upwardly somewhat during thermal drive-in. However, because the n+ dopant ions are selected to diffuse more slowly than the p+ dopant ions, the buried layer expands by a significantly lesser amount than the contact layer 50. Also, although shown as being of approximately equal vertical extent, the depth of upper isolation ring portion 54 will actually be about twice that of the lower portion 52 as a result of both a greater initial p+ deposition, and the fact that the substrate 34 itself tends to diffuse upward when heated.

In the next step of fabrication, shown in FIG. 6, p+ concentrations 60 are deposited in the upper surfaces of lateral contact regions 58, and thermally driven-in by a short heating step at about 1,100°C. This is a conventional technique for establishing a better electrical contact with the doped semiconductor (in this case the contact regions 58) by metallic contacts added in a subsequent step.

Referring next to FIG. 7, an n+ cathode region 62 has been added over anode region 56 by first depositing a concentration of a suitable dopant, such as $p_2O_5$, in the upper surface of the device, and then thermally driving the n+ concentration into contact with the anode region by a low temperature thermal drive-in, typically at about 950°C. This results in an interface or junction 64 between the n+ cathode 62 and p+ anode 56 across which zener action takes place. The zener junction is isolated from the surface of the device by the surrounding epitaxial layer, resulting in a true buried diode.

There is some tolerance in the various dopant levels. However, an average range of about $10^{17}$-$10^{18}$ ions/cc for the "up" and "down" p+ diffusions with a higher concentration of about $10^{19}$ ions/cc in the vicinity of the diode junction 64, and an n+ concentration of about $5 \times 10^{20}$ ions/cm. in the cathode region 62, are suitable.

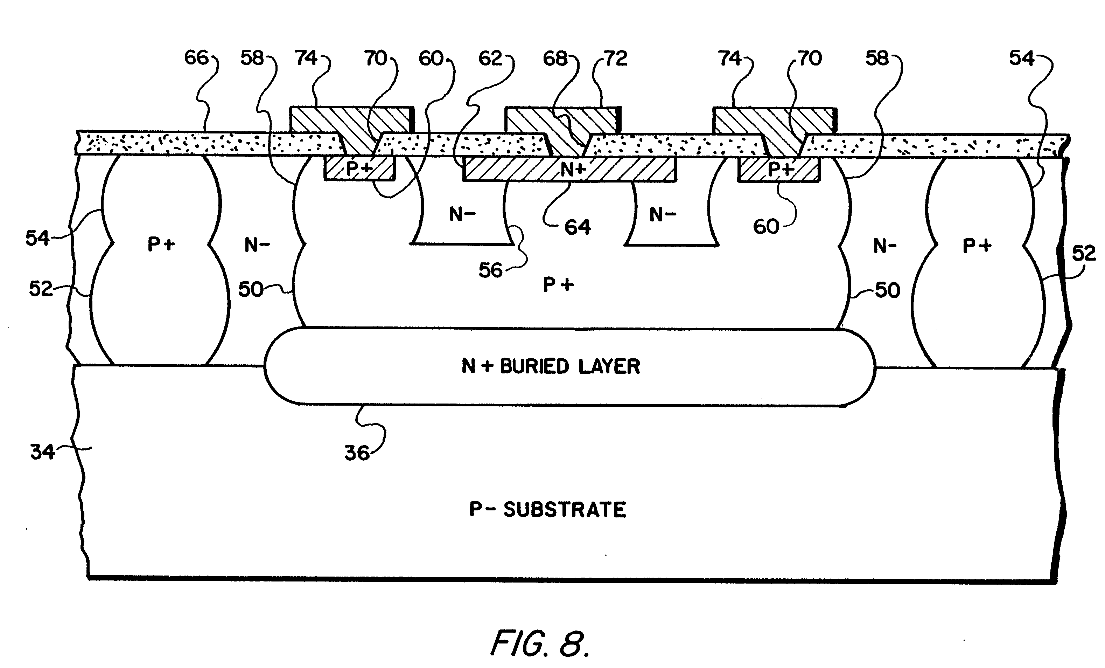

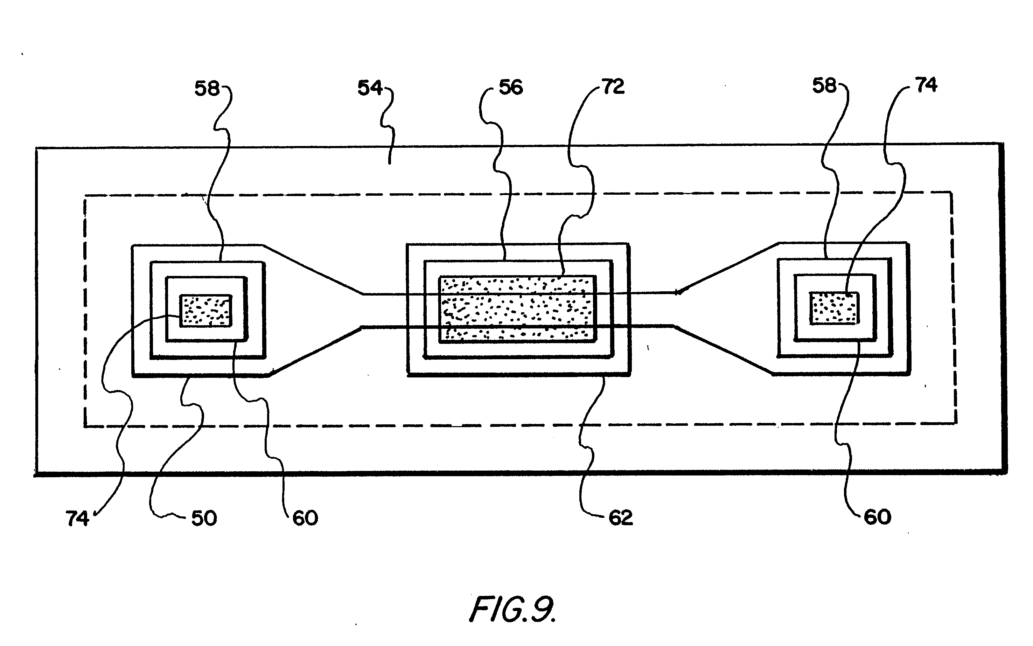

In the final fabrication step, the results of which are shown in FIGS. 8 and 9, an insulative oxide layer 66 is laid down over the upper surface of the device, windows 68 and 70 are etched through the oxide layer in registration with cathode 62 and lateral contacts 60, respectively, and metallic contacts are formed through the windows to establish the basic electrical contacts with the diode. As shown, the cathode contact 72 extends through window 68, while the dual anode contacts 74 extend through window 70.

The result is a buried zener diode which requires fewer fabrication steps than previous devices, and by eliminating the prior p- well avoids the parasitic resistances associated therewith. It should be recognized that numerous modifications and alternate embodiments will occur to those skilled in the art. For example, although it may not be desirable to do so because of fabrication difficulties, the polarity of the device could be reversed. Accordingly, it is intended that the invention be limited only in terms of the appended claims.

## Claims

1. A buried zener diode structure, comprising:
a semiconductor substrate (34) doped to a first polarity,
a buried layer (36) extending into the upper surface of said substrate (34) and doped to a second polarity opposite to said first polarity,
a contact layer (50) extending up from said buried layer (36) and doped to said first polarity, said contact layer (50) being junction isolated by said buried layer (36) from said substrate (34),
lateral contact regions (58) extending up from respective lateral portions of said contact layer (50) and doped to said first polarity,
a doped central zener diode anode region (56) extending up from a central portion of said contact layer (50) and doped to said first polarity, said central anode region (56) being spaced inwardly from said lateral contact regions (58) and electrically connected therewith through said contact layer (50), and
a zener diode cathode region (62) doped to said second polarity, said cathode region (62) being disposed over said central anode region (56) and forming a buried zener diode junction (64) therewith.

2. The buried zener diode structure of claim 1, wherein said contact layer (50), lateral contact regions (58) and anode regions (56) are set in an epitaxial layer (42) grown from said substrate (34).

3. The buried zener diode structure of claim 2, wherein said lateral contact regions (58) and said anode region (56) comprise thermal diffusions from respective doping source regions (46, 44) in the upper portion of said epitaxial layer (42).

4. The buried zener diode structure of claim 3, wherein said contact layer (50) comprises a thermal diffusion from a doping source region (38) in said buried layer (36).

5. A method of forming a buried zener diode, comprising:
forming a doped buried layer (36) in the upper surface of a doped substrate (34), the substrate (34) being doped to a first polarity and the buried layer (36) to a second polarity opposite to said first polarity,
forming an epitaxial layer (42) over said substrate (34) and buried layer (36),
forming a) a contact layer (50) upon said buried layer (36), and b) the lower portion (52) of an isolation ring in the epitaxial layer (42) spaced from and surrounding said contact layer (50), said contact layer (50) and lower isolation ring portion (52) being formed in a first common series of process steps and doped to said first polarity,
forming a) lateral contact regions (58) on respective lateral portions of said contact layer (50), b) a central contact region (56) on a central portion of said contact layer (50), and c) an upper portion (54) of said isolation ring, said lateral contact regions (58), central contact region (56), and upper isolation ring portion (54) all being doped to said first polarity, and
forming a zener diode cathode region (62) doped to said second polarity over said central contact region (56) to establish a buried zener diode junction (64) therewith.

6. The method of claim 5, wherein said first common series of process steps comprised depositing first doping concentrations (38, 40) of said first polarity in said buried layer (36) and in the substrate (34) in alignment with the isolation ring location, and heating the device to diffuse dopant ions from said concentrations (38, 40) into the epitaxial layer (42), and said second common series of process steps comprises depositing second doping concentrations (46, 44, 48) of said first polarity into the upper portion of said epitaxial layer (42) in alignment with the lateral contact region (58), the central contact region (56) and the isolation ring locations (54), and heating the device to diffuse dopant ions from said second concentrations (46, 44, 48) into said epitaxial layer (42), said deposition and heating steps being controlled so that said lateral contact regions (58) and central contact regions (56) extend into said contact layer (50), and said upper (54) and lower (52) isolation ring portions meet.

7. The method of claim 6, wherein dopant ions from said first (38, 40) and second (46, 44, 48) doping concentrations are diffused in a single heating step.

8. The method of claim 7, wherein said epitaxial layer (42) is formed after said first doping concentrations (38, 40) are deposited but before said second doping concentrations (46, 44, 48) are deposited.

9. The method of claim 8, wherein the buried layer dopant has a slower rate of diffusion than said first polarity dopant.

10. The method of claim 7, further comprising the steps of forming an insulating oxide layer (66) over said epitaxial layer (42), forming windows in said oxide layer (66) in alignment with said lateral contact regions (58) and cathode region (62), and depositing contacts through said windows to the underlying zener diode structure.

32  16  22  26  20        24  14  10    26  20  22  32

18

28

P+

P−        P+        P−

P+        8

N-EPI

12

N+ BURIED LAYER

30

30

P- SUBSTRATE

## FIG. I. (PRIOR ART)

36

N+ BURIED LAYER

34

P- SUBSTRATE

## FIG. 2.

40        38                        40

P+        P+                        P+

34

36        N+ BURIED LAYER

P- SUBSTRATE

## FIG. 3.

FIG.4.

FIG.5.

FIG.6.

FIG.7.

FIG. 8.

EP 0 314 399 A2

FIG.9.